# EUROPEAN PATENT SPECIFICATION

(11) **EP 3 559 305 B1**
(45) Date of publication and mention of the grant of the patent: **16.07.2025**
(21) Application number: 17816651.8
(22) Date of filing: 07.12.2017
(51) Int. Cl.: C23C 14/24, C23C 14/26, C23C 14/56

(54) **ROLL-TO ROLL VAPOR DEPOSITION SYSTEM**
ROLLE-ZU-ROLLE-SYSTEM ZUR AUFDAMPFUNG
SYSTÈME ROULEAU À ROULEAU DE DÉPÔT EN PHASE VAPEUR

(30) Priority: 22.12.2016 EP 16206188
(43) Date of publication of application: 30.10.2019
(73) Proprietor: Flisom AG, 8155 Niederhasli (CH)
(72) Inventor: KAELIN, Marc, 8155 Niederhasli (CH)
(74) Representative: Zimmermann & Partner Patentanwälte mbB
(86) International application number: PCT/EP2017/081928
(87) International publication number: WO 2018/114379

(56) References cited:
- WO-A1-2009/033503
- WO-A1-2017/001910
- JP-A- 2012 052 180
- TW-A- 201 122 128
- US-A- 2 440 135
- US-A1- 2001 005 553

## Description

### Field of the invention

The present invention relates to a roll-to roll vapor deposition system with evaporation sources used for vapor deposition of material onto substrates and more particularly for controlled material coating of large substrates, such as vacuum deposition on large sheets or using roll-to-roll processes.

In particular, the present invention relates to roll-to roll vapor deposition system with linear evaporation sources usable for vapor deposition of In, Ga and Cu for controlled material coating of large flexible substrates in vacuum using the roll-to-roll process for the production of thin films of CIGS (Cu(In,Ga)Se2, copper indium gallium di selenide).

The deposition of thin films of CIGS (CulnGaSe2, copper indium gallium di selenide) onto a flexible substrate is an important process step in the industrial manufacturing of solar panels and photovoltaic cells, which convert solar energy into electrical energy basing on the specific physical properties of said CIGS thin film.

In the following, CIGS thin film means a CIGS film exhibiting a thickness between 50 and 0.1 micrometers, most preferably between 5 and 0.5 micrometers.

### Background of the invention

Coating of objects using thermal evaporation requires a crucible to heat up and vaporize material that deposits itself onto a substrate. The deposition usually takes place within a vacuum chamber, thereby imposing spatial and physical constraints. Space may be especially constrained in the case of roll-to-roll deposition where the roll-to-roll mechanism must be contained within a desirably small vacuum chamber. Physical constraints are also strong in the case of coevaporation using multiple adjacent sources operating at different regulated temperatures to deposit material with a desired distribution and thickness onto a moving substrate.

A source for vapor deposition of material onto a roll-to-roll web ordinarily comprises: an elongated crucible that contains the material to be vaporized, at least one electrical heating element to direct the vaporized material flux onto the nearby moving web substrate. Several evaporation sources, also known as evaporation boats, may be arranged parallel to each other to deposit larger quantities of material and/or different materials onto the moving substrate.

It is often necessary to regulate the flux of material leaving the crucible to achieve a controlled deposition thickness and composition along the length and the width of the moving substrate. The flux of material and its distribution is related to the crucible's temperature distribution and also to the distribution and shape of the openings that let the evaporated material flow out of the crucible. The temperature distribution within a crucible is ordinarily spatially non-uniform, and therefore related to the electrical power delivered to the heating elements at various locations within the evaporation source's assembly. U.S. patent 2,440,135 (also published as G.B. patent application 554,312) describes an apparatus for thermal evaporation in vacuum chambers comprising a container that itself comprises a metal tube extending across the container in the path of flow of the vapor to the openings structure, said metal tube being traversed by an electric resistance heater. European patent application EP1662017A1 (also published as U.S. Pat. App. No. 2006/0291825A1) describes an arrangement for vaporizing materials comprising three heating circuits, two of which are provided to regulate the longitudinal distribution of temperature by independently and externally heating two halves of the crucible's vaporizer tube. Japanese patent application JP 2005-13673 (also published as U.S. Pat. App. No. 2009/0173279A1) describes a crucible divided into a plurality of independently heated regions located under the crucible's lower surface. JP2012052180 discloses a method for the deposition of a CIGS thin-film on a web with a roll-to-roll vapor deposition system comprising a vacuum deposition chamber enclosing three sets of linear evaporation sources, filled with In, Ga, Cu or Se. WO2009033503 discloses adjusting the deposition rate of evaporation sources during deposition of a CIGS film. TW201122128 discloses a linear evaporation source apparatus comprising an elongated horizontal crucible, a heater, and a plurality of nozzles on a face of a lid of the apparatus that is parallel to the longest centerline of the crucible, some of the nozzles being oriented orthogonally to the surface of the lid.

### Summary of the invention

A problem in the field of thermal vapor deposition relates to the regulation of the thickness distribution and composition of the material layers deposited on a substrate using evaporation sources. This problem is especially acute with large substrates. It is therefore an object of the current invention to provide an evaporation source that enables spatial and time regulation of material deposited on a moving substrate such as a roll-to-roll web substrate.

Another problem in the field of thermal vapor deposition relates to the limited volume of the vacuum chambers where evaporation takes place, thereby imposing spatial constraints on the size of the sources used, the energy they consume and radiate, and their influence on the reliability of the entire vacuum deposition system. It is therefore a further object of the current invention to provide an evaporation source that is compact but whose design can readily be lengthened by a person ordinarily skilled in the art, can be combined into an array of sources, and enables fast regulation of material deposition with the benefits of low energy consumption, increased longevity, and reduced costs.

A further problem in the field of thermal vapor deposition relates to the efficiency of the deposition with respect to evaporated material consumption and especially to the changes in efficiency as the level within the evaporation source of material to be evaporated changes. It is therefore also a further object of the current invention to provide an evaporation source that consumes less material and energy than conventional evaporation sources to achieve a uniform deposition and to provide an evaporation source that can adapt to changes within the evaporation source of the level of material to be evaporated.

Yet a further problem in the field of thermal vapor deposition relates to the undesired deposition of material droplets, also known as spitting, onto the substrate. It is therefore yet a further object of the current invention to provide an evaporation source that reduces or prevents problems associated with spitting or projection of material droplets.

Also, a further problem in the field of thermal vapor deposition during long deposition cycles relates to the falling of material flakes or other particles into the evaporation source. It is therefore also an object of the current invention to provide an evaporation source that prevents problems associated with falling material flakes.

The invention is set out in the appended set of claims.

The invention's features advantageously solve several problems in the field of thermal vapor deposition, namely:
- The roll-to roll vapor deposition system enables independent regulation of flux in all desired directions while advantageously offering the possibility to minimize the number and size of heating elements with the further benefit of energy savings,
- The roll-to roll vapor deposition system with opportune positioning of the evaporation source sets advantageously reduce the roll-to roll vapor deposition system's volume and keep the material hot at the surface where evaporation occurs, thereby permitting a faster response to changes in temperature of the heating elements and subsequent energy savings.
- The roll-to roll vapor deposition system advantageously helps to solve the problem of uneven spatial distribution of the deposited material and reduce energy expense to obtain a uniform and controlled deposition profile.
- The nozzles having a flux-wise axis that is oriented at between +30 and +150 degrees with respect to the plane supporting the base of the nozzles advantageously helps to increase the deposition quality over a larger deposition area, especially in the case of roll-to-roll applications where a moving substrate might not be planar. The nozzles with variable inclination allow to direct always the evaporated flux orthogonally to an adjacent surface of a web, even when said web exhibits different and/or variable slopes and orientations in respect to the ground.
- The obstruction of the line of sight from outside the evaporation source apparatus to the material to be evaporated by the inclined nozzles advantageously prevents: spits of molten material from the crucible towards the substrate, bouncing of condensed droplets also thanks to heating of the lid or crucible surface closest to the substrate, and spitting through the nozzles thanks to nozzles lips being heated and inclined.
- The roll-to roll vapor deposition system advantageously reduce the complexity of mechanical construction in comparison to configurations found in the prior art, thereby increasing reliability and reducing assembly cost.
- The roll-to roll vapor deposition system advantageously insulates the evaporation sources and therefore reduces the amount of heat radiated to adjacent objects.
- The roll-to roll vapor deposition system advantageously reduces the possibility of material depositing onto other surfaces than the one of the web.

### Brief description of figures

Embodiments of the invention will now be described by way of example, with reference to the accompanying drawings, in which:
FIGS. 1A-1E show in perspective and cross-sectional views an evaporation source comprising a crucible closed by a lid with lip joints, a set of three coaxial heating rods, temperature sensors, nozzles, and heat shields (FIGS. 1D and 1E). Cross-sections 1C and 1E detail the evaporation source of FIGS. 1B and 1D with molten material at the bottom of the crucible.
FIGS. 2A-2E show individual heating coil elements and their mating as a 3-component heating coil assembly placed inside a tube that is then inserted into a crucible comprising temperature sensors and nozzles.
FIGS. 3A-3C show an evaporation source comprising three parallel heating rods, two side heaters, temperature sensors, lid, and nozzles. Alternative embodiments have one and three rows of nozzles.
FIGS. 4A-4D show two different evaporation sources where nozzles are located on the side of the evaporation source, either as part of the crucible's lid or as part of the crucible.
FIG. 5 is a graph comparing deposition profiles when using one or three heating elements.
FIGS. 6A-6B show electrical diagrams of two alternative equivalent circuits for the heating elements of the evaporation sources of FIGS. 1A-4D along with their power supplies.
FIG. 7 shows a schematic diagram of a feedback loop to regulate heaters of the evaporation source.
FIGS. 8A-8B show two exemplary embodiments of vapor deposition systems to illustrate how the evaporation sources are used.

### Detailed description of specific embodiments

The exemplary embodiments presented in this disclosure show the roll-to roll vapor deposition system with at least three sets of at least three evaporation sources, the evaporation source comprising a crucible, itself comprising at least three heating elements, at least one of which is contained within said crucible. The crucible is ordinarily closed by a lid. The heating element located within the crucible is positioned close to the top of the crucible and close to nozzle orifices present either in the lid or near the top of one of the crucible's long walls. Said nozzles may be shaped/oriented so as to direct the vapor flux in a desired direction. This proximity of the inner heating element to the nozzles ensures firstly that the heating elements block the line of sight from outside the evaporation source through the nozzles towards the material to be evaporated, and secondly that the nozzles are heated.

Someone skilled in the art will appreciate that the scales of the various components represented in the figures have been changed to improve clarity. Furthermore, the number and areas of components in the figures can be scaled up. However, the crucible will preferably keep approximately its illustrated configuration and proportions where the crucible is an elongated hollow body of rectangular or trapezoidal cross-section having a substantially flat bottom, a substantially flat top which is larger than the bottom, substantially flat side walls that may be, in the case of a trapezoidal cross-section, slightly inclined outwardly from the bottom to the top, as shown, and relatively small substantially flat rectangular or trapezoidal end walls. The crucible length is normally at least 3 times and preferably at least 5 times or even 8 times longer than its outer width at the top.

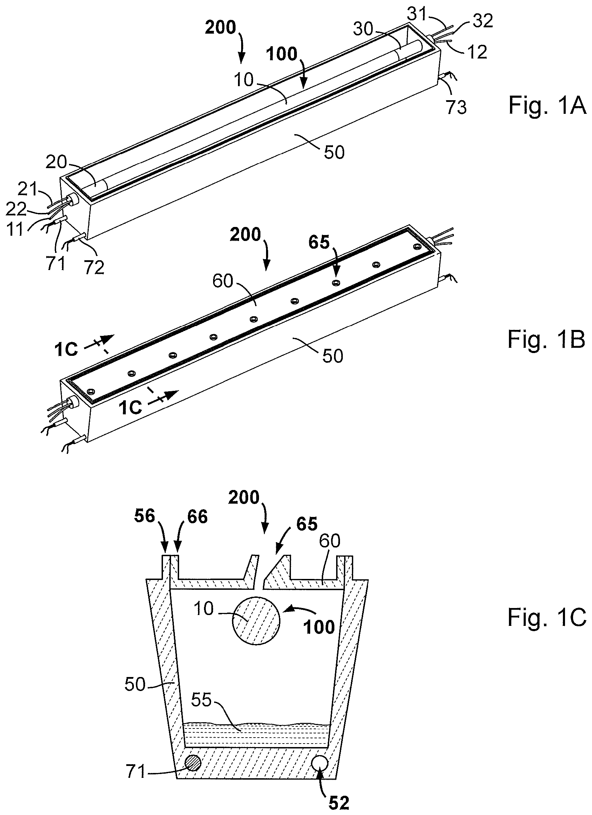

FIGS. 1A-1E present a first embodiment with three longitudinally-aligned coaxial heating rods.

FIG. 1A shows an embodiment of an evaporation source 200 comprising an elongated generally rectangular crucible 50 and a heater assembly 100 composed of three axially aligned heating rods 20, 10, 30. Heater assembly 100 is supported at each end by passing through a support hole in each short face of crucible 50 and positioned close to the crucible's opening or top so that there is no contact between said heater assembly and molten material 55 to be evaporated present at the bottom of crucible 50 during ordinary operation. Heating rods 10, 20, and 30 are powered via pairs of insulated contacts 11, 12, 21, 22, and 31, 32, respectively. Evaporation source 200 comprises at least three temperature sensors 71, 72, 73 positioned against or, as shown in Fig. 1C, inside the thickness of, the lower surface of crucible 50. Each temperature sensor 71, 72, 73 preferably extends so as to provide temperature of the material to be evaporated at a position situated under the mid-length of each heating rod 10, 20, 30 of heater assembly 100, respectively.

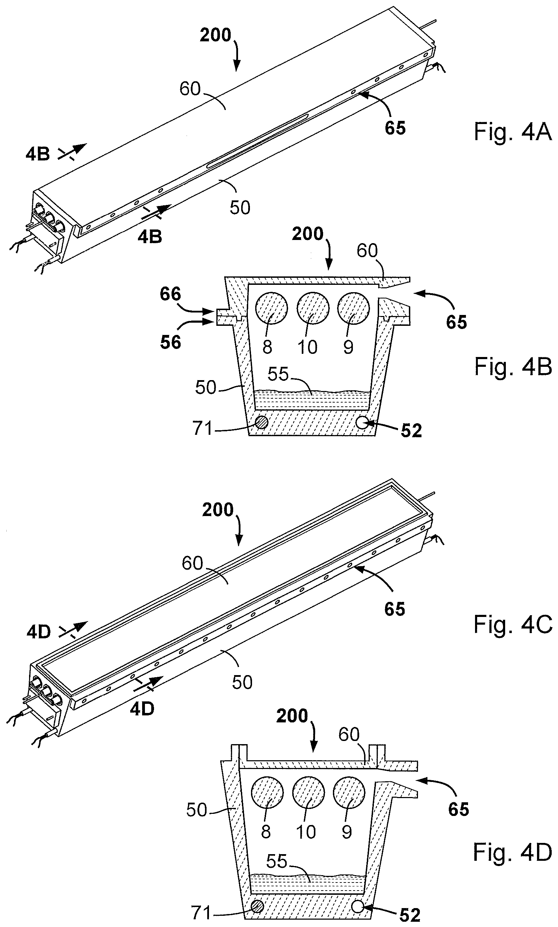

FIG. 1B shows a preferred embodiment of the evaporation source 200 of FIG. 1A where crucible 50 is closed by lid 60. Crucible 50 and lid 60 are ordinarily made of a refractory material for example primarily containing alumina (Al₂O₃), silica, boron nitride, graphite, molybdenum, tantalum, or tungsten. Lid 60 comprises at least one nozzle 65 positioned over heater assembly 100. Lid 60 preferably comprises a plurality of nozzles 65 wherein no nozzle 65 provides a line of sight from outside crucible 50 to the surface of the material to be evaporated contained within crucible 50. Furthermore, although the nozzles 65 may ordinarily be designed so as to direct the evaporated flux orthogonally to the surface of lid 60, in this embodiment the nozzles are inclined, as shown in the cross-section of FIG. 1C. Although the channel of nozzles 65 is represented as being divergent, someone ordinarily skilled in the art may choose to design a different channel such as straight, convergent, convergent-divergent, differently divergent, and/or as an elongated slit so as to advantageously shape the pattern of material deposition onto the substrate. The cross-section of an embodiment with convergent-divergent nozzles is presented in FIG. 4D. Furthermore, although FIG. 1B presents one row of uniformly distributed nozzles 65, it is also possible to have a non-uniform distribution of nozzles 65, as presented in FIG. 4A.

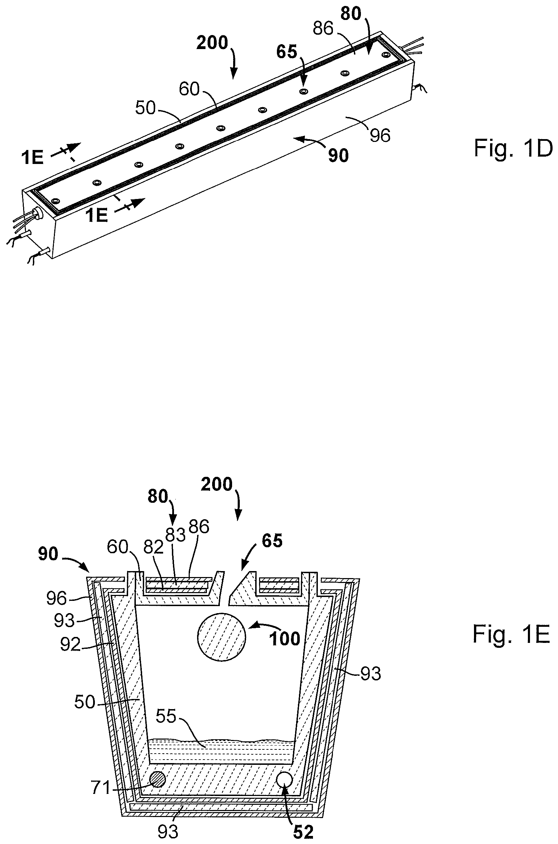

FIG. 1C shows a cross-section of an embodiment of evaporation source 200 of FIG. 1B with molten material to be evaporated 55 at the bottom of crucible 50 occupying typically up to about 20-25% or up to 50% of the crucible's depth without touching any heating element. Lid 60 closes crucible 50. The crucible is ordinarily able to contain an amount of molten material to be evaporated enabling the coating of 2000 meters to 5000 meters of substrate. Heater assembly 100, represented in this cross-section by the centermost or principal heating rod 10, is placed close to nozzles 65 so that no line of sight is established from outside crucible 50 to the surface of molten material 55. Molten material 55 is typically a metal such as copper, indium, gallium, selenium, zinc, tin, gold, chrome, antimony, sodium, magnesium, aluminium, germanium, nickel, silver, cadmium, lead or other materials to be evaporated with a boiling point from 100 degrees Celsius to 2000 degrees Celsius. Temperature sensor 71 is also present in the cross-section of the crucible bottom. Hole 52 serves in this embodiment as a channel for temperature sensor 72 in case there is a need to measure temperatures closer to the mid-length of crucible 50. FIG. 1C illustrates how the channel of nozzle 65 may be designed so as to direct the evaporated flux at an angle that is not orthogonal to the plane of lid 60. The angle at which nozzle 65 is oriented will ordinarily be between +30° and +150° with respect to the plane onto which nozzle 65 is fitted, in the present case the plane of lid 60. FIG. 1C also shows how crucible 50 and lid 60 are provided with respective extended lips 56, 66 at the perimeter where they are in contact. The pair of lips 56, 66 acts as a circumferential joint which may also channel the vapor flux of material 55 that may leak through the pair of lips 56, 66 between crucible 50 and lid 60. Said lips 56, 66 help reduce the amount of material that may deposit on an optional heat shield assembly presented in FIGS.1D-1E.

FIG. 1D shows the preferred embodiment of evaporation source 200 of FIG. 1B surrounded by heat shields comprising lid heat shield assembly 80 and crucible heat shield assembly 90. Said heat shield assemblies 80, 90 are detailed in the cross-section of FIG. 1E. FIG. 1D therefore only shows the outer layer of the heat shield assemblies 80, 90 comprising lid outer shield 86 placed on lid 60 but leaving clearance for nozzles 65, and crucible outer shield 96 wrapped around crucible 50 till the edges of lid 60. Said heat shields advantageously reduce radiation of heat away from the evaporation source, thereby reducing energy consumption and furthermore reducing the amount of heat radiated towards the substrate onto which the material is deposited, and/or towards adjacent components such as other evaporation sources and/or the evaporation source's supporting infrastructure.

FIG. 1E shows a cross-section detailing the heat shield assemblies 80, 90 of the preferred embodiment of evaporation source 200 of FIG. 1D. As in FIG. 1C, evaporation source 200 contains molten material to be evaporated 55 heated by heater assembly 100 within crucible 50 closed by lid 60. Crucible 50 also comprises temperature sensor 71 and temperature sensor channel 52. Said heat shield assemblies 80, 90 comprise at least one shielding layer and are represented in this figure by a three-layer shield assembly. Someone ordinarily skilled in the art will infer that the number, size, thickness, and spacing of shields may be varied. Lid heat shield assembly 80 comprises inner shield 82, middle shield 83, and outer shield 86. Crucible heat shield assembly 90 comprises inner shield 92, middle shields 93, and outer shield 96. A better thermal shielding is usually obtained by providing some separation between shields 82, 83, 86 and 92, 93, 96 so that their surfaces do not contact each other. Inner and outer shields 82, 92, 86, 96 are ordinarily made of high-temperature resistant material such as molybdenum, tantalum, tungsten, niobium, rhenium, or titanium. Middle shields 83, 93 are ordinarily made of a refractory material for example primarily containing alumina (Al₂O₃), silica, boron nitride, or felt made of carbon or graphite.

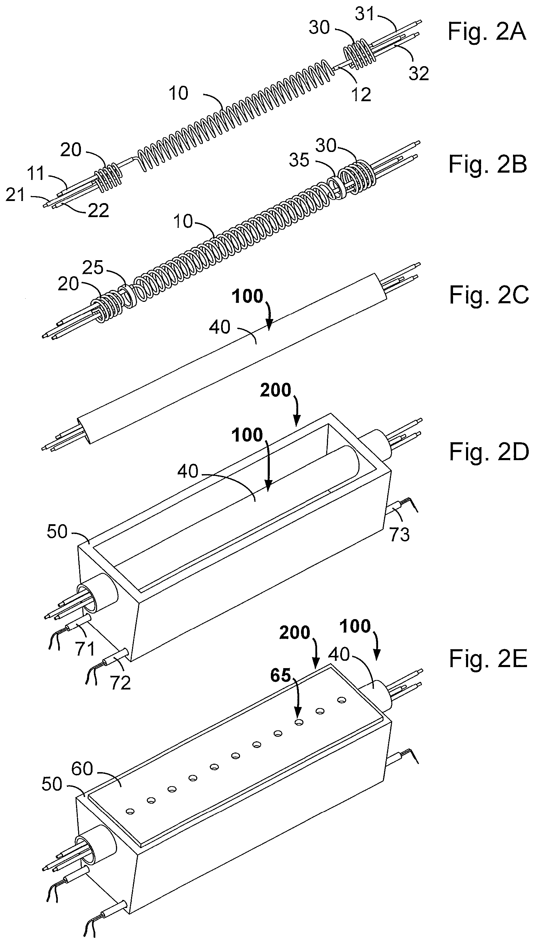

FIGS. 2A-2E present perspective views of a second embodiment with three coaxial axially-aligned heating coils.

FIG. 2A shows an assembly of three axially aligned electrical heating coils 10, 20, 30. The central heating coil 10 is powered at each of its extremities via extended insulated contacts 11, 12. Insulated contacts 11, 12 are located close to the common axis of heating coils 10, 20, 30 and extend in a direction parallel to said common axis. Heating coil 20 is located at one of the extremities of heating coil 10 and surrounds insulated contact 11. Heating coil 30 is located at the other extremity of heating coil 10 and surrounds insulated contact 12. Heating coils 20 and 30 are powered via insulated contacts 21, 22 and 31, 32, respectively. Heating coils 10, 20, 30 may be of the same or different lengths, the same or different diameters, and have the same or different and non-uniform numbers of turns per unit length. In the preferred illustrated example, the central heating coil 10 is longer than the end heating coils 20, 30, all coils having approximately the same diameter.

FIG. 2B shows said assembly of FIG. 2A optionally complemented with electrical insulators 25, 35 in the form of rings or discs positioned between heating coils 20, 10, 30. Electrical insulators 25, 35 are ordinarily made of a refractory non-electrically conducting material for example primarily containing alumina, silica, zirconia toughened alumina, steatite, or mullite.

FIG. 2C shows heater assembly 100 where said assembly of FIG. 2A or FIG. 2B is inserted into electrically insulating heater tube 40. Heater tube 40 is ordinarily made of a refractory, non-electrically conducting material for example primarily containing alumina, silica, zirconia toughened alumina, steatite, or mullite.

FIG. 2D shows an embodiment of an evaporation source 200 comprising a crucible 50, ordinarily an elongated container of trapezoidal cross-section made of refractory material, and a heater assembly 100 aligned with the crucible's long centerline and passing through corresponding holes in each trapezoid short side. Heater tube 40 is positioned close to the crucible's opening or top so that the material to be evaporated, also called a melt, remains at the crucible's bottom and below heater tube 40 during ordinary operation. Evaporation source 200 further comprises at least three temperature sensors 71, 72, 73, such as thermocouples, positioned against the part of crucible 50 containing said melt. Temperature sensors 71, 72, 73 are preferably positioned within dedicated channels inside the thickness of the crucible's lower surface and extend so as to provide temperature of the melt region situated preferably under the mid-length of each heating coil 10, 20, 30 of heater assembly 100, respectively.

FIG. 2E shows a preferred embodiment of the evaporation source 200 of FIG. 2D closed by lid 60. Lid 60 comprises at least one nozzle 65, for example as illustrated a line of nozzles distributed along the length of crucible 50, positioned over heating tube 40 and such that no nozzle 65 provides a line of sight from outside crucible 50 to the surface of said melt.

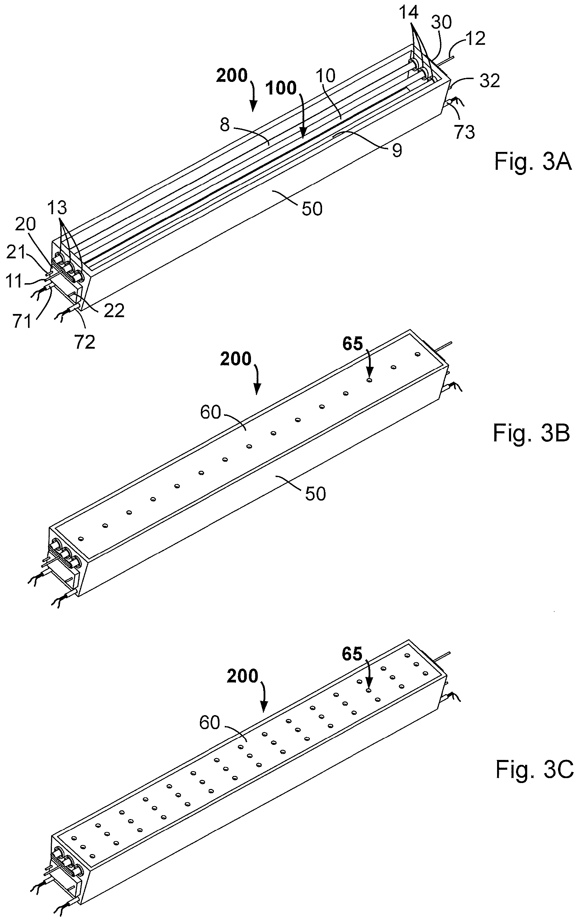

FIGS. 3A-3C present perspective views of a third embodiment with three principal parallel heating rods and two external side-end heaters.

FIG. 3A shows an alternate embodiment of an evaporation source 200 comprising a crucible 50 that comprises a heater assembly 100 comprising three parallel heating rods 8, 9, 10 positioned side-by-side along the length of crucible 50. Heating rods 8, 9, 10 are supported at each end by passing through electrically insulating support holes 13, 14 in each short face of crucible 50 and positioned close to the opening or top of crucible 50 so that there is no contact between said heating rods and the liquid melt present at the bottom of crucible 50 during ordinary operation. Heating rods 8, 9, 10 are electrically connected in parallel so as to represent a single heating element and powered via insulated contacts 11, 12. Someone ordinarily skilled in the art will infer that heating rods 8, 9, 10 may also be connected in series or any combination of parallel and series, or that the number of heating rods positioned within crucible 50 and close to its top may be increased. Heating assembly 100 further comprises side heaters 20 and 30 that are mounted outside crucible 50 against each short face and powered by contacts 21, 22 and 31, 32, respectively. It is understood that if the crucible 50 is surrounded by heat shields as in Figs. 1D and 1E, the side heaters 20 and 30 will be located inside the heat shields. Similarly to crucibles 50 of embodiments presented in FIGS. 1B and 2D, crucible 50 comprises at least three temperature sensors 71, 72, 73 positioned against, or inside the thickness of, the lower surface of crucible 50. Temperature sensor 71 preferably extends till the mid-length of heating rods 8, 9, 10. Temperature sensors 72, 73 preferably extend at most one third of the length of heating rods 8, 9, 10.

FIG. 3B shows the embodiment of evaporation source 200 of FIG. 3A closed by lid 60. Lid 60 comprises at least one nozzle 65, for example as illustrated a line of nozzles distributed along the length of lid 60, positioned over heater assembly 100 and such that no nozzle 65 provides a line of sight from outside crucible 50 to the surface of the melt within said crucible.

FIG. 3C shows an alternative embodiment of evaporation source 200 of FIG. 3B where lid 60 comprises 3 rows of, in this example fifteen, nozzles 65 distributed along the length of the lid, positioned over heating rods 8, 9, 10 and such that no nozzle 65 provides a line of sight from outside crucible 50 to the surface of the melt within said crucible.

FIGS. 4A-4D present perspective and cross-sectional views of fourth and fifth embodiments where nozzles are located on the side of the source. Said fourth and fifth embodiments are designed for evaporation deposition tasks where the substrate is located or moves along the side of the evaporation source, such as in roll-to-roll coating of flexible substrates.

FIG. 4A shows the fourth embodiment, which is an alternative embodiment of evaporation source 200 of FIG. 3B where crucible 50 has at least one of its long walls cut out so as to support an extended lid 60 bearing at least two faces: a top face and at least one side face. One of the side faces of lid 60 comprises at least one nozzle 65, in this example a line of nozzles comprising a combination of circular and slit nozzles, so arranged that no nozzle 65 provides a line of sight from outside crucible 50 to the surface of the melt 55 within said crucible. FIG. 4A also shows that nozzles 65 are not distributed evenly along the side face of lid 60.

FIG. 4B shows a cross-section of the embodiment of evaporation source 200 of FIG. 4A. It is conceptually similar to the cross-section of FIG. 1C with a crucible 50 containing molten material to be evaporated 55 at its bottom and comprising temperature sensor 71, temperature sensor channel 52, three parallel heating rods 8, 9, 10, and lid 60 bearing nozzles 65. FIG. 4B details how the walls of crucible 50 differ from that of FIG. 1C: the shape of crucible 50 is modified to support lid 60 bearing side-facing nozzles 65. FIG. 4B also shows that the line of sight from outside evaporation source 200 through nozzles 65 towards the material to be evaporated 55 is obstructed by heating rod 9. Evaporation source 200 also comprises extended lips 56, 66 as a provision to reduce deposition of vaporized material 55 onto an optional (not presented in this figure) shield assembly 90 that would be conceptually similar to that presented in FIG. 1E.

FIG. 4C shows an alternative embodiment of evaporation source 200 of FIG. 3B where crucible 50 has a row of nozzles 65 close to the top of one of its side walls. In this embodiment the lid 60 bears no nozzles.

FIG. 4D shows a cross-section of the embodiment of evaporation source 200 of FIG. 4C. It is conceptually similar to the cross-section of FIG. 1C with a crucible 50 containing molten material to be evaporated 55 at its bottom and comprising temperature sensor 71, temperature sensor channel 52, three parallel heating rods 8, 9, 10, and a lid 60 that bears no nozzles. In this embodiment, it is crucible 50 that bears convergent-divergent nozzles 65 close to the top of one of its side walls that runs parallel to heating rod 9. FIG. 4D also shows that the line of sight from outside evaporation source 200 through nozzles 65 towards the material to be evaporated 55 is obstructed by heating rod 9.

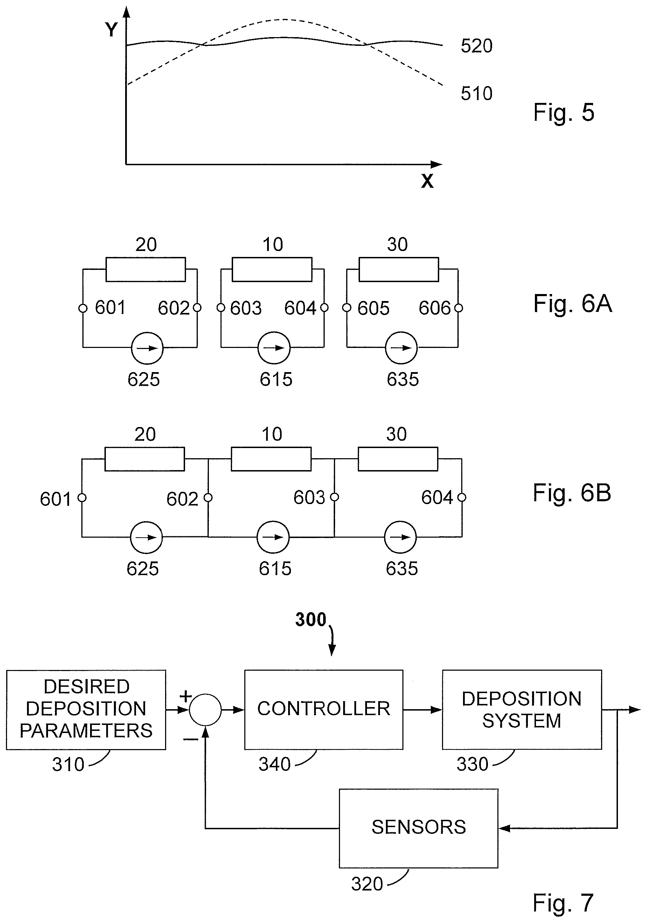

FIG. 5 shows a graph comparing the deposition profile, for example thickness Y of material deposited on a planar substrate, versus position X along the long axis of evaporation source 200. Curve 510 represents the deposition profile for an evaporation source that would have only one full-length operating heating element, for example the evaporation source 200 of FIG. 3A-3D where only heating rods 8, 9, 10 would be switched on but where side heaters 20, 30 would remain switched off. Curve 510 therefore represents a deposition profile with a relatively large amount deposited towards the centerline of the deposition area, whereas a comparatively lesser amount is deposited towards the edge of the deposition area. Curve 520 represents the deposition profile for an evaporation source according to an embodiment of this invention that would have all heating elements switched on and regulated so as to produce a more uniform deposition profile.

FIGS. 6A-6B present two alternative electrical circuits to power said evaporation sources.

FIG. 6A shows a schematic diagram of an electrical circuit to power the independently regulated electrical heating components of evaporation source 200 represented in FIGS. 1A-1E, 2A-2E, 3A-3C, 4A-4D. Heating elements 20, 10, and 30 are powered via pairs of lines (601, 602), (603, 604), and (605, 606) by power supplies 625, 615, and 635, respectively.

FIG. 6B shows a schematic diagram of a preferred electrical circuit to power the independently regulated electrical heating components of evaporation source 200 represented in FIGS. 1A-1E, 2A-2E, 3A-3C, 4A-4D. In order to reduce the number of electrical cables, heating components 10, 20, 30 share some common lines 602, 603 to connect to their respective electrical power supplies 615, 625, 635. A common line 602 is shared by heating elements 10, 20 to connect to respective power supplies 625, 615. In the same way, line 603 connects resistors 10, 30 to their respective power supplies 615, 635. Each end of the heating element network is supplied by unshared lines 601, 604. More generally, if there are N independently regulated heating components, only N+1 lines are needed to connect to the power supplies.

FIG. 7 shows the block diagram of a control system 300 to regulate the vapor deposition process. The "Desired Deposition Parameters" block 310 represents values set by an operator via a user interface. The "Desired Deposition Parameters" block 310 may include desired evaporation source temperature values but more preferably, in the context of a complete evaporation system comprising multiple evaporation sources, desired thickness and relative composition distribution of the material deposited on the substrate. The "Sensors" block 320 therefore represents data acquired not only from temperature sensors 71, 72, 73, but also from other sensors that can for example measure the thickness and relative composition distribution of the material deposited on the substrate. The "Deposition

System" block 330 represents the system that incorporates at least one evaporation source 200. The "Controller" block 340 represents a real-time control computation that uses the difference between values set in the "Desired Deposition Parameters" block 310 and values acquired by the "Sensors" block 320 to compute commands for the "Deposition System" block 330, such as commands to the electrical power supplies of heating elements 10, 20, 30.

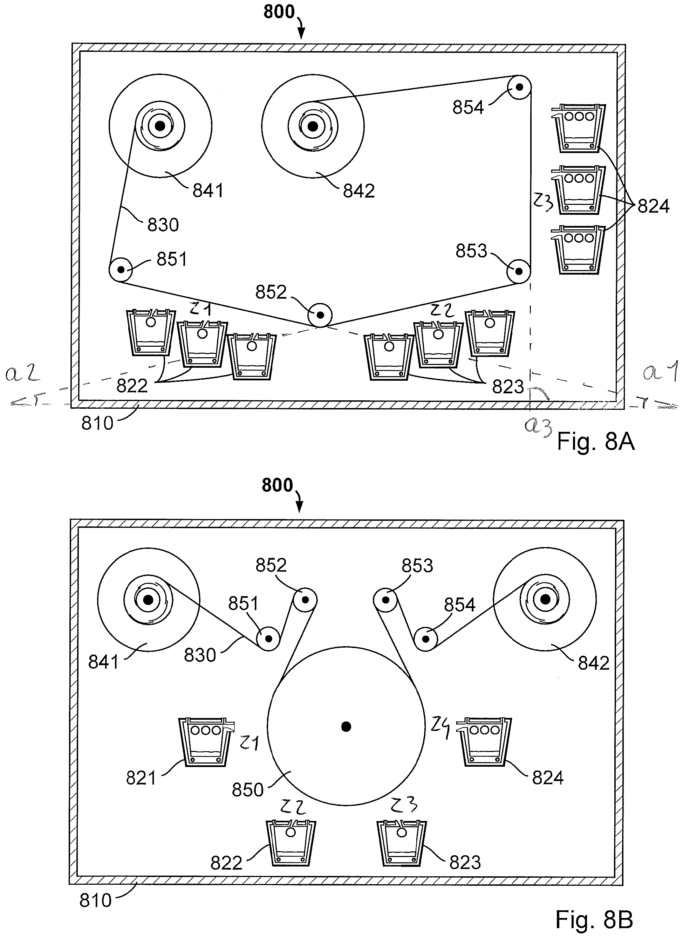

FIGS. 8A-8B show two exemplary embodiments of vapor deposition systems to illustrate how the evaporation sources are be used.

FIG. 8A shows a frontal cross section of a free span roll-to-roll vapor deposition system 800. Vacuum deposition chamber 810 encloses three sets of three evaporation sources 822, 823, 824 selected from the embodiments presented in FIGS. 1A to 4D, namely FIGS. 1E and 4D. Web 830, for example made of polyimide or stainless steel, departs pay-off roll 841 and gets coated by sets of evaporation sources 822, 823, 824 as it travels between tensioning rolls 851, 852, 853, 854, respectively, until it gets rolled-up by take-up roll 842. Sets of evaporation sources 822 and 823 are staged so as to follow the slope of web 830. Set of evaporation sources 824 is staged vertically to match the vertical path of web 830 between tensioning rolls 853 and 854.

Vacuum deposition chamber 810 exhibits a vacuum higher than 10-4 Pa, preferably higher than 10-5 Pa, more preferably higher than 10-6 Pa before the start of the coating evaporation process.

In the roll-to roll vapor deposition system (800) each set (822, 823, 824) of evaporation sources comprises at least one evaporation source apparatus containing In, at least one evaporation source apparatus containing Ga, and at least one evaporation source apparatus containing Cu, whereby In, Ga and Cu are contained in a crucible (50) in order to be melted and evaporated.

The roll-to roll vapor deposition system (800) exhibits at least three different deposition zones (Z1, Z2, Z3) characterized by at least three different slopes and orientations (a1, a2, a3) exhibited by web (830) in respect to the ground, wherein each deposition zone (Z1, Z2, Z3) comprises a set (822, 823, 824) of evaporation sources positioned adjacent to the web (830) in said zone.

The roll-to roll vapor deposition system (800) exhibits at least three different deposition zones (Z1, Z2, Z3) characterized also by at least three different deposition rates and/or deposition ratios of different atoms (r1, r2, r3) realized by the sets (822, 823, 824) of evaporation sources, wherein each deposition zone (Z1, Z2, Z3) comprises a set (822, 823, 824) of evaporation sources positioned adjacent to the web (830) in said zone and tuned and configured to achieve said deposition rate and/or deposition ratio of different atoms (r1, r2, r3).

In the roll-to roll vapor deposition system (800) the at least three evaporation source apparatuses of each set of evaporation sources (822, 823, 824) exhibit nozzles (65) having a flux-wise axis always oriented perpendicularly to the adjacent surface of web (830), so as to direct always the evaporated flux orthogonally to the adjacent surface of the web (830).

In the roll-to roll vapor deposition system (800) said nozzles (65) are inclined, and have a flux-wise axis that is oriented at between +30 degrees and +80 degrees with respect to the plane supporting the base of the nozzles (65), preferably between +40 and +70 degrees, most preferably between +45 and +60 degrees, so as to direct the evaporated flux away from the orthogonal to said plane supporting said base.

In the roll-to roll vapor deposition system (800) said nozzles (65) exhibits a channel having a flux-wise axis, said channel exhibiting a length longer than its width and a divergent cross section, i.e. a cross-section along a plane containing the flux-wise axis larger at the nozzle outlet than at the nozzle inlet, so as to be configured to convey the evaporated material (55) on the largest possible surface of the adjacent thin web (830).

In the roll-to roll vapor deposition system (800) said nozzles (65) exhibit a position, a size and an inclination, so that there is no line of sight from outside the evaporation source apparatus (200) to the material to be evaporated (55) through the nozzles (65), said line of sight being obstructed by the nozzles (65).

For the deposition of thin CIGS films on a thin web (830) with a roll-to roll vapor deposition system (800), the web (830), for example made of polymer or metal foil, departs a pay-off roll (841), gets coated with a thin CIGS film by said evaporation sources sets (822, 823, 824) as it travels between tensioning rolls (851, 852, 853, 854) until it gets rolled-up by take-up roll (842).

The deposition of thin CIGS films on a thin web (830) with a roll-to roll vapor deposition system (800) comprises at least the following three different deposition stages, characterized by at least three different deposition rates and/or deposition ratios of different atoms (r1, r2, r3) realized by the at least three sets (822, 823, 824) of evaporation sources, each positioned in its respective deposition zone (Z1, Z2, Z3):
Stage 1: the ratio (r1) between the deposition rate of Cu and the total summed deposition rate of In and Ga is < 1, preferably < 0.5, more preferably < 0.1;
Stage 2: the ratio (r2) between the deposition rate of Cu and the total summed deposition rate of In and Ga is >1, preferably > 2, more preferably > 3;
Stage 3: the ratio (r3) between the deposition rate of Cu and the total summed deposition rate of In and Ga is < 1, preferably < 0.5, more preferably < 0.1.

During the deposition of thin CIGS films on a thin web (830) with a roll-to roll vapor deposition system (800) the at least three different deposition stages, characterized by the at least three different deposition rates and/or deposition ratios of different atoms (r1, r2, r3) realized by the at least three sets (822, 823, 824) of evaporation sources, each positioned in its respective deposition zone (Z1, Z2, Z3), exhibit the following deposition rates:
Stage 1: the deposition rate of Cu is < 3, preferably < 1, more preferably < 0.1 Angstrom/s;
Stage 2: the deposition rate of Cu is > 0.2, preferably > 1, more preferably > 2 Angstrom/s;
Stage 3 the deposition rate of Cu is < 3, preferably < 1, more preferably < 0.1 Angstrom/s.

FIG. 8B shows a cross section of a drum-based roll-to-roll vapor deposition system 800. Vacuum deposition chamber 810 encloses four evaporation source sets 821, 822, 823, 824 selected from the embodiments presented in FIGS. 1A to 4D, namely FIGS. 1E and 4D.

Only one evaporation source per set is depicted in the figure for convenience and clarity, while each set comprises actually at least 3 evaporation sources.

Web 830 departs pay-off roll 841, passes tensioning rolls 851, 852 and gets coated by evaporation source sets 821, 822, 823, 824 as it is carried against deposition drum 850. Web 830 then continues to tensioning rolls 853, 854 until it gets rolled-up by take-up roll 842. Evaporation source sets 821, 822, 823, 824 are staged around deposition drum 850 so as to follow its curvature.

The exemplary embodiments represented in the present disclosure offer a number of advantages for vapor deposition, especially in the context of large area or roll-to-roll deposition, with respect to deposition regulation and quality as well as space and energy savings.

A first advantage results from the use of the evaporation source sets able to direct the evaporated flux in a predetermined direction along the evaporation source's length to solve the problem of uneven spatial distribution of the deposited material. Deposition with conventional crucibles ordinarily exhibits a decay of evaporated material deposition profile towards the extremities of the crucible's long axis. The decay is ordinarily compensated for a set point by supplying more heat to the crucible. The benefit of using evaporation source sets able to direct the evaporated flux in a predetermined direction is that the resulting deposition profile is more uniform at less energy expense while being easily adaptable via regulation of the independent power supplies.

Also, depletion of material in conventional evaporation sources usually results in changes in the deposition profile. The multiple evaporation source sets able to direct the evaporated flux in a predetermined direction decrease this physical effect. A further advantage of this disclosure is that the heat needed to produce a desired deposition profile and composition can be tuned as the material to be evaporated depletes within the evaporation source or as the heat shields experience changes in their properties. Independent adjustments of the heat produced by the heating elements therefore regulate the evaporation profile and composition. Furthermore, said adjustments prevent the onset of unwanted vapor flow along the crucible's long axis.

In the context of an installation within a vacuum deposition chamber where various devices such as shields or even adjacent evaporation sources installed as an array may temporarily affect a given source's thermal characteristics, the ability to continuously regulate the evaporation profile and composition is especially beneficial for vapor deposition onto large substrates, for example roll-to-roll webs 0.5 meters wide or more, or also glass substrates larger than 0.5 meters in width or length. It then becomes possible to advantageously integrate an evaporation sources feedback control function as part of an evaporation source system. Said feedback control function would at least use temperatures measured by the evaporation source's temperature sensors and possibly also measurements of the material deposited onto the substrate.

The need for compact and closely integrated arrays of evaporation sources is an incentive towards reducing the number of power lines and FIG. 6B therefore presents an advantageous cabling solution to electrically connect heating elements to power supplies. Furthermore, using shared power lines may, under some conditions, enable to reduce the electrical current flowing through some of the lines, thereby further simplifying the cabling between heating elements and power supplies.

An advantage of placing the heating assembly directly above the material to be evaporated is that the surface where evaporation occurs is heated first, thereby permitting a faster response of the evaporation flux to changes in temperature of the heating assembly. Energy may then be saved thanks to reduced thermal inertia of the combined heating assembly and molten material system.

Furthermore, placing the heating assembly mainly within the crucible rather than outside is beneficial to reduce the evaporation source's volume. This is especially advantageous for use within vacuum deposition chambers where several evaporation sources are used within a restricted volume. For example in the context of a co-evaporation vacuum deposition chamber, it is advantageous to have evaporation sources arranged in parallel and close to each other. Also, the coaxial configuration of the heating assembly presented in the embodiments of FIGS. 1 and 2 reduces the complexity of external wiring needed to power the heating elements in comparison to configurations found in prior art. Benefits of this reduction in wiring are increased overall reliability and reduction of assembly cost.

Another advantage of the evaporation source sets' design is that the crucible and its lid can feature joining lips to channel and direct vapor leaks away from heat shields. Said shields, optionally placed around the crucible and against the lid, insulate the source and therefore reduce the amount of heat radiated to adjacent objects. However, said shields may see their insulating properties diminished if material deposits onto them, hence the design of the extended joining lips to reduce the possibility of material depositing onto the shields.

Finally, placing the heating assembly directly under the lid has several combined advantages: the heating assembly blocks the line of sight between the melt within the crucible and the deposition substrate, therefore preventing detrimental spits of molten material from the crucible towards the substrate; the lid is also heated preferably to a higher temperature than the crucible by the heating assembly, therefore providing a simple way to prevent the formation of condensed material droplets that could either clog the nozzles or fall onto the heating element, thereby creating spitting, or fall further into the molten material and create internal splashes that may be detrimental to the uniformity of the deposition. Said placement of the heating assembly in effect provides a so-called "hot lip source" without requiring the addition of a lip heater. Furthermore, the embodiments presented in FIGS. 1A-4D show that lip heating and line of sight obstruction can be effective both when the nozzles are above or to the side of the heating assembly.

In order to depose thin CIGS films onto a flexible polymer foil (polyimide), a roll-to roll vapor deposition system (800) according to the invention was actually built for the deposition of thin CIGS films on a thin web (830), comprising a vacuum deposition chamber (810) enclosing at least three evaporation sources (822, 823, 824), containing respectively In, Ga and Cu, whereby web (830), made of polyimide foil, departs a pay-off roll (841) and gets coated by said evaporation sources (822, 823, 824) as it travels between tensioning rolls (851, 852, 853, 854) until it gets rolled-up by take-up roll (842).

With such an equipment a 2.5 micrometer thin CIGS film has been actually deposited onto the flexible polymer substrate. According to such a method for the deposition of thin CIGS films on a thin web (830) with a roll-to roll vapor deposition system (800) according to the invention comprising a vacuum deposition chamber (810) enclosing at least three evaporation sources (822, 823, 824), containing respectively In, Ga and Cu, the web (830), made of polymer foil, departs a pay-off roll (841), gets coated with a thin CIGS film by said evaporation sources (822, 823, 824) as it travels between tensioning rolls (851, 852, 853, 854) until it gets rolled-up by take-up roll (842).

Details of the performed process can be found in US 8 927 051, WO 2014/097112 and EP 2 647 033.

Photovoltaic cells and photovoltaic modules for the conversion of solar energy into electrical energy comprising said thin CIGS film deposited on a thin web (830), specifically a polyimide foil, had been manufactured and had exhibited an efficiency between 12 and 16%.

Details of the production method can be found in WO2015/1144498, US 8 928 105 and WO 2016/108079 .

## Claims

1. A roll-to-roll vapor deposition system (800) suited for the deposition of thin CIGS (Cu(In,Ga)Se₂, copper indium gallium di selenide) films on a
thin web (830) comprising a vacuum deposition chamber (810) enclosing at least three sets (822, 823, 824) of evaporation sources, each set comprising at least three evaporation source apparatuses (200), whereby the web (830), for example made of polymer or metal foil, departs a pay-off roll (841) and gets coated by said evaporation sources sets (822, 823, 824) as it travels on a path between tensioning rolls (851, 852, 853, 854) until it gets rolled-up by a take-up roll (842),
wherein the at least three evaporation source apparatuses (200) are linear evaporation source apparatuses (200) for atomic vapor deposition of metal atoms suited for the production of CIGS thin films comprise:
at least one elongated horizontal crucible (50) for containing, up to a given level in the crucible (50), material (55) to be melted and evaporated,
a heater assembly (100), and
a plurality of nozzles (65) that have an inclination,
wherein the plurality of nozzles (65) are on a face of the apparatus that is parallel to the longest centerline of the crucible (50), the plurality of nozzles (65) have a flux-wise axis that is oriented towards the path of the web at between +45 degrees and +60 degrees with respect to the plane supporting the base of the plurality of nozzles (65), so as to direct the evaporated flux in a predetermined direction.

2. A roll-to roll vapor deposition system (800) according to any of the preceding claims, whereby each set (822, 823, 824) of evaporation sources comprises at least three evaporation source apparatuses, each one containing a different material (55) than the two others, selected from the group of In, Ga, Cu, Se and Na, whereby said material (55) is contained in a crucible (50) in order to be melted and evaporated.

3. A roll-to roll vapor deposition system (800) according to any of the preceding claims, exhibiting at least three different deposition zones (Z1, Z2, Z3) **characterized by** at least three different slopes and orientations (a1, a2, a3) exhibited by the web (830) with respect to the ground, wherein each deposition zone (Z1, Z2, Z3) comprises a set (822, 823, 824) of evaporation sources positioned adjacent to the web (830) in said zone.

4. A roll-to roll vapor deposition system (800) according to any of the preceding claims, wherein the at least three evaporation source apparatuses of each set of evaporation sources (822, 823, 824) exhibit nozzles (65) having a flux-wise axis always oriented perpendicularly to the adjacent surface of web (830).

5. A roll-to roll vapor deposition system (800) according to any of the preceding claims, wherein the plurality of nozzles (65) exhibits a channel having a flux-wise axis, said channel exhibiting a length longer than its width and a divergent cross section that is larger at the nozzle outlet than at the nozzle inlet, so as to be configured to convey the evaporated material (55) on the largest possible surface of the adjacent thin web (830).

6. A roll-to roll vapor deposition system (800) according to any of the preceding claims, whereby each set (822, 823, 824) of evaporation sources comprises at least one evaporation source apparatus containing In, at least one evaporation source apparatus containing Ga, and at least one evaporation source apparatus containing Cu, whereby In, Ga and Cu are contained in a crucible (50) in order to be melted and evaporated.

7. A method for the deposition of thin CIGS films on a thin web (830) with a roll-to roll vapor deposition system (800) according to any of the preceding claims, **characterized in that** the web (830), for example made of polymer or metal foil, departs a pay-off roll (841), gets coated with a thin CIGS film by said evaporation sources sets (822, 823, 824) as it travels between tensioning rolls (851, 852, 853, 854) until it gets rolled-up by a take-up roll (842).

8. The method for the deposition of thin CIGS films on a thin web (830) according to claim 6 with a roll-to roll vapor deposition system (800) comprising at least three different deposition stages, **characterized by** at least three different deposition rates and/or deposition ratios of different atoms (r1, r2, r3) realized by at least three sets (822, 823, 824) of evaporation sources, each positioned in its respective deposition zone (Z1, Z2, Z3):
Stage 1: the ratio (r1) between the deposition rate of Cu and the total summed deposition rate of In and Ga is < 1, preferably < 0.5, more preferably < 0.1;
Stage 2: the ratio (r2) between the deposition rate of Cu and the total summed deposition rate of In and Ga is >1, preferably > 2, more preferably > 3;
Stage 3: the ratio (r3) between the deposition rate of Cu and the total summed deposition rate of In and Ga is < 1, preferably < 0.5, more preferably < 0.1.

9. The method for the deposition of thin CIGS films on a thin web (830) according to claim 7 with a roll-to roll vapor deposition system (800) according to claims 6 and 8, whereby the at least three different deposition stages, **characterized by** the at least three different deposition rates and/or deposition ratios of different atoms (r1, r2, r3) realized by the at least three sets (822, 823, 824) of evaporation sources, each positioned in its respective deposition zone (Z1, Z2, Z3), exhibit the following deposition rates:
Stage 1: the deposition rate of Cu is < 3, preferably < 1, more preferably < 0.1 Angstrom/s;
Stage 2: the deposition rate of Cu is > 0.2, preferably > 1, more preferably > 2 Angstrom/s;
Stage 3 the deposition rate of Cu is < 3, preferably < 1, more preferably < 0.1 Angstrom/s.

## Patentansprüche

1. Ein Rolle-zu-Rolle-Dampfabscheidungssystem (800), das für die Abscheidung dünner Schichten aus CIGS (Cu(In,Ga)Se2, Kupfer-, Indium- und Galliumdiselenid) auf einem dünnen Band (830) geeignet ist, umfasst eine Vakuumabscheidungskammer (810), die mindestens drei Sätze (822, 823, 824) von Verdampfungsquellen umschließt, wobei jeder Satz mindestens drei Verdampfungsquellenvorrichtungen (200) umfasst, die Bahn (830), die beispielsweise aus einem Polymer oder einer Metallfolie besteht, von einer Startwalze (841) ausgeht und durch die Verdampfungsquellenanordnungen (822, 823, 824) beschichtet wird, während sie sich auf einem Weg zwischen Spannwalzen (851, 852, 853, 854) bewegt, bis sie von einer Antriebswalze (842) aufgewickelt wird,
wobei die mindestens drei Verdampfungsquellenvorrichtungen (200) lineare Verdampfungsquellenvorrichtungen (200) für die atomare Abscheidung von Metallatomen aus der Dampfphase sind, die für die Herstellung von CIGS-Dünnschichten geeignet sind, umfassend:
mindestens einen länglichen horizontalen Tiegel (50), um das zu schmelzende und zu verdampfende Material (55) bis zu einem bestimmten Pegel im Tiegel (50) aufzunehmen,
eine Heizanordnung (100), und
eine Vielzahl von Düsen (65), die eine Neigung aufweisen,
wobei sich die Mehrzahl von Düsen (65) auf einer Seite der Vorrichtung befindet, die parallel zur längsten Mittellinie des Schmelztiegels (50) verläuft, die Mehrzahl von Düsen (65) eine Strömungsachse hat, die in Richtung des Weges des Streifens zwischen +45 Grad und +60 Grad in Bezug auf die Ebene, die die Basis der Vielzahl von Düsen (65) trägt, ausgerichtet ist, um so die verdampfte Strömung in eine vorbestimmte Richtung zu lenken.

2. Rolle-zu-Rolle-Dampfabscheidungssystem (800) nach einem der vorhergehenden Ansprüche, wobei jeder Satz (822, 823, 824) von Verdampfungsquellen mindestens drei Verdampfungsquellenvorrichtungen umfasst, von denen jede ein Material (55) enthält, das sich von den anderen beiden unterscheidet und aus der Gruppe In, Ga, Cu, Se und Na ausgewählt ist, wobei das Material (55) in einem Tiegel (50) enthalten ist, um geschmolzen und verdampft zu werden.

3. Rolle-zu-Rolle-Dampfabscheidungssystem (800) nach einem der vorhergehenden Ansprüche, das mindestens drei verschiedene Abscheidungszonen (Z1, Z2, Z3) aufweist, die durch mindestens drei verschiedene Neigungen und Ausrichtungen (a1, a2, a3) gekennzeichnet sind, die das Band (830) in Bezug auf den Boden aufweist, wobei jede Abscheidungszone (Z1, Z2, Z3) eine Anordnung (822, 823, 824) von Verdampfungsquellen umfasst, die in der Nähe des Bandes (830) in der Zone positioniert sind.

4. Rolle-zu-Rolle-Dampfabscheidungssystem (800) nach einem der vorhergehenden Ansprüche, wobei die mindestens drei Verdampfungsquellenvorrichtungen jedes Satzes von Verdampfungsquellen (822, 823, 824) Düsen (65) mit einer Strömungsachse aufweisen, die immer senkrecht zu der benachbarten Oberfläche der Bahn (830) ausgerichtet ist.

5. Rolle-zu-Rolle-Dampfabscheidungssystem (800) nach einem der vorhergehenden Ansprüche, wobei die Vielzahl von Düsen (65) einen Kanal mit einer Strömungsachse aufweist, wobei der Kanal eine Länge aufweist, die größer ist als seine Breite, und einen divergierenden Querschnitt, der am Düsenauslass größer ist als am Düseneinlass, so dass er so konfiguriert ist, dass er das verdampfte Material (55) über die größtmögliche Fläche des angrenzenden dünnen Streifens (830) transportiert.

6. Rolle-zu-Rolle-Dampfabscheidungssystem (800) nach einem der vorhergehenden Ansprüche, wobei jeder Satz (822, 823, 824) von Verdampfungsquellen mindestens eine In enthaltende Verdampfungsquellenvorrichtung, mindestens eine Ga enthaltende Verdampfungsquellenvorrichtung und mindestens eine Cu enthaltende Verdampfungsquellenvorrichtung umfasst, wobei das In, Ga und Cu in einem Schmelztiegel (50) enthalten sind, um geschmolzen und verdampft zu werden.

7. Verfahren zum Abscheiden dünner CIGS-Schichten auf einem dünnen Band (830) unter Verwendung eines Rolle-zu-Rolle-Dampfabscheidungssystems (800) nach einem der vorhergehenden Ansprüche, **dadurch gekennzeichnet, dass** das Band (830), das beispielsweise aus einem Polymer oder einer Metallfolie besteht, von einer Ausgangsrolle (841) ausgeht, durch die Verdampfungsquellenanordnungen (822, 823, 824) mit einem dünnen CIGS-Film beschichtet wird, während sie zwischen Spannrollen (851, 852, 853, 854) reist, bis sie von einer Aufnahmerolle (842) aufgewickelt wird.

8. Verfahren zum Abscheiden dünner CIGS-Schichten auf einem dünnen Band (830) nach Anspruch 6 mit einem Rolle-zu-Rolle-Dampfabscheidungssystem (800), das mindestens drei verschiedene Abscheidungsschritte umfasst, die durch mindestens drei verschiedene Abscheidungsraten und/oder Atomabscheidungsverhältnisse (r1, r2, r3) gekennzeichnet sind, die durch mindestens drei Sätze (822, 823, 824) von Verdampfungsquellen erzielt werden, die jeweils in ihrem jeweiligen Abscheidungsbereich (Z1, Z2, Z3) positioniert sind :
Schritt 1: Das Verhältnis (r1) zwischen der Abscheidungsgeschwindigkeit von Cu und der gesamten Abscheidungsgeschwindigkeit plus In und Ga beträgt < 1, bevorzugt < 0,5, noch bevorzugter < 0,1;
Schritt 2: Das Verhältnis (r2) zwischen der Cu-Abscheidungsrate und der gesamten, mit In und Ga addierten Abscheidungsrate ist > 1, vorzugsweise > 2, stärker bevorzugt > 3 ;
Schritt 3: Das Verhältnis (r3) zwischen der Cu-Abscheidungsrate und der gesamten Abscheidungsrate, die mit In und Ga addiert wird, ist < 1, vorzugsweise < 0,5, noch bevorzugter < 0,1.

9. Verfahren zum Abscheiden dünner CIGS-Schichten auf einem dünnen Band (830) nach Anspruch 7 mit einem Rolle-zu-Rolle-Dampfabscheidungssystem (800) nach Anspruch 6 und 8, wobei die mindestens drei unterschiedlichen Abscheidungsschritte **dadurch gekennzeichnet sind, dass** die mindestens drei unterschiedlichen Abscheidungsschritte Dampfabscheidungsschritte sind, **gekennzeichnet durch** mindestens drei verschiedene Ablagerungsraten und/oder Ablagerungsverhältnisse verschiedener Atome (r1, r2, r3), die von den mindestens drei Sätzen (822, 823, 824) von Verdampfungsquellen, die jeweils in ihrer jeweiligen Ablagerungszone (Z1, Z2, Z3) positioniert sind, durchgeführt werden, die folgenden Ablagerungsraten aufweisen:
Phase 1: Die Cu-Abscheidungsrate beträgt < 3, vorzugsweise < 1, besonders bevorzugt < 0,1 Angstrom/s ;
Stufe 2: Die Cu-Ablagerungsrate ist > 0,2, vorzugsweise > 1, stärker bevorzugt > 2 Angstrom/s ;
Stufe 3: Die Cu-Ablagerungsgeschwindigkeit beträgt < 3, vorzugsweise < 1, besser < 0,1 Angstrom/s.

## Revendications

1. Un système de dépôt en phase vapeur de rouleau à rouleau (800) adapté au dépôt de couches minces de CIGS (Cu(In,Ga)Se₂, diséléniure de cuivre, d'indium et de gallium) sur une bande mince (830) comprenant une chambre de dépôt sous vide (810) renfermant au moins trois ensembles (822, 823, 824) de sources d'évaporation, chaque ensemble comprenant au moins trois dispositifs de source d'évaporation (200), la bande (830), par exemple constituée d'un polymère ou d'une feuille métallique, part d'un rouleau de départ (841) et est enduite par lesdits ensembles de sources d'évaporation (822, 823, 824) alors qu'elle se déplace sur un chemin entre des rouleaux de tension (851, 852, 853, 854) jusqu'à ce qu'elle soit enroulée par un rouleau d'entraînement (842),
dans lequel les au moins trois dispositifs de sources d'évaporation (200) sont des dispositifs sources d'évaporation linéaires (200) pour le dépôt atomique en phase vapeur d'atomes métalliques adaptés à la production de couches minces CIGS, comprenant:
au moins un creuset horizontal allongé (50) pour contenir, jusqu'à un niveau donné dans le creuset (50), le matériau (55) à fondre et à évaporer,
un ensemble de chauffage (100), et
une pluralité de buses (65) ayant une inclinaison,
dans lequel la pluralité de buses (65) se trouve sur une face du dispositif qui est parallèle à la ligne centrale la plus longue du creuset (50), la pluralité de buses (65) a un axe de flux qui est orienté vers le chemin de la bande entre +45 degrés et +60 degrés par rapport au plan supportant la base de la pluralité de buses (65), de façon à diriger le flux évaporé dans une direction prédéterminée.

2. Système de dépôt en phase vapeur de rouleau à rouleau (800) selon l'une quelconque des revendications précédentes, dans lequel chaque ensemble (822, 823, 824) de sources d'évaporation comprend au moins trois dispositifs de sources d'évaporation, chacun contenant un matériau (55) différent des deux autres, choisi dans le groupe In, Ga, Cu, Se et Na, ledit matériau (55) étant contenu dans un creuset (50) afin d'être fondu et évaporé.

3. Système de dépôt en phase vapeur de rouleau à rouleau (800) selon l'une quelconque des revendications précédentes, présentant au moins trois zones de dépôt différentes (Z1, Z2, Z3) **caractérisées par** au moins trois pentes et orientations différentes (a1, a2, a3) présentées par la bande (830) par rapport au sol, dans lequel chaque zone de dépôt (Z1, Z2, Z3) comprend un ensemble (822, 823, 824) de sources d'évaporation positionnées à proximité de la bande (830) dans ladite zone.

4. Système de dépôt en phase vapeur de rouleau à rouleau (800) selon l'une quelconque des revendications précédentes, dans lequel les au moins trois dispositifs de source d'évaporation de chaque ensemble de sources d'évaporation (822, 823, 824) présentent des buses (65) ayant un axe de flux toujours orienté perpendiculairement à la surface adjacente de la bande (830).

5. Système de dépôt en phase vapeur de rouleau à rouleau (800) selon l'une quelconque des revendications précédentes, dans lequel la pluralité de buses (65) présente un canal ayant un axe de flux, ledit canal présentant une longueur supérieure à sa largeur et une section transversale divergente qui est plus grande à la sortie de la buse qu'à l'entrée de la buse, de manière à être configuré pour transporter le matériau évaporé (55) sur la plus grande surface possible de la bande mince adjacente (830).

6. Système de dépôt en phase vapeur de rouleau à rouleau (800) selon l'une quelconque des revendications précédentes, dans lequel chaque ensemble (822, 823, 824) de sources d'évaporation comprend au moins un dispositif de source d'évaporation contenant de l'In, au moins un dispositif de source d'évaporation contenant du Ga, et au moins un dispositif de source d'évaporation contenant du Cu, dans lequel l'In, le Ga et le Cu sont contenus dans un creuset (50) afin d'être fondus et évaporés.

7. Procédé de dépôt de couches minces de CIGS sur une bande mince (830) à l'aide d'un système de dépôt en phase vapeur de rouleau à rouleau (800) selon l'une quelconque des revendications précédentes, **caractérisé en ce que** la bande (830), par exemple constituée d'un polymère ou d'une feuille métallique, part d'un rouleau de départ (841), est revêtue d'un film CIGS mince par lesdits ensembles de sources d'évaporation (822, 823, 824) alors qu'elle voyage entre des rouleaux de tension (851, 852, 853, 854) jusqu'à ce qu'elle soit enroulée par un rouleau de réception (842).

8. Procédé de dépôt de couches minces de CIGS sur une bande mince (830) selon la revendication 6 avec un système de dépôt en phase vapeur de rouleau à rouleau (800) comprenant au moins trois étapes de dépôt différentes, **caractérisées par** au moins trois taux de dépôt et/ou rapports de dépôt d'atomes différents (r1, r2, r3) réalisés par au moins trois ensembles (822, 823, 824) de sources d'évaporation, chacun positionné dans sa zone de dépôt respective (Z1, Z2, Z3) :
Étape 1 : le rapport (r1) entre la vitesse de dépôt de Cu et la vitesse de dépôt totale additionnée de In et de Ga est < 1, préférablement < 0,5, plus préférablement < 0,1 ;
Étape 2 : le rapport (r2) entre la vitesse de dépôt du Cu et la vitesse de dépôt totale additionnée de In et de Ga est > 1, préférablement > 2, plus préférablement > 3 ;
Étape 3 : le rapport (r3) entre la vitesse de dépôt du Cu et la vitesse de dépôt totale additionnée de In et de Ga est < 1, préférablement < 0,5, plus préférablement < 0,1.

9. Procédé de dépôt de couches minces de CIGS sur une bande mince (830) selon la revendication 7 avec un système de dépôt en phase vapeur de rouleau à rouleau (800) selon les revendications 6 et 8, dans lequel les au moins trois étapes de dépôt différentes sont **caractérisées en ce que** les au moins trois étapes de dépôt différentes sont des étapes de dépôt en phase vapeur, **caractérisés par** au moins trois taux de dépôt différents et/ou rapports de dépôt de différents atomes (r1, r2, r3) réalisés par les au moins trois ensembles (822, 823, 824) de sources d'évaporation, chacun positionné dans sa zone de dépôt respective (Z1, Z2, Z3), présentent les taux de dépôt suivants :
Phase 1 : la vitesse de dépôt du Cu est < 3, préférablement < 1, plus préférablement < 0,1 Angstrom/s ;
Stade 2 : la vitesse de dépôt du Cu est > 0,2, préférablement > 1, plus préférablement > 2 Angstrom/s ;
Étape 3 : la vitesse de dépôt du Cu est < 3, préférablement < 1, plus préférablement < 0,1 Angstrom/s.
